# EUROPÄISCHE PATENTSCHRIFT

(11) **EP 4 317 520 B1**
(45) Veröffentlichungstag und Bekanntmachung des Hinweises auf die Patenterteilung: **17.12.2025**
(21) Anmeldenummer: 23216135.6
(22) Anmeldetag: 20.04.2020
(51) Int. Cl.: C23C 14/02, C23C 16/01, C23C 16/26

(54) **VERFAHREN ZUR HERSTELLUNG EINES TRÄGERSUBSTRATES**
METHOD FOR PRODUCING A CARRIER SUBSTRATE
PROCÉDÉ DE FABRICATION D'UN SUBSTRAT DE SUPPORT

(43) Veröffentlichungstag der Anmeldung: 07.02.2024
(62) Teilanmeldung aus: 20720808.3
(73) Patentinhaber: EV Group E. Thallner GmbH, 4782 St. Florian am Inn (AT)
(72) Erfinder: Burggraf, Jürgen, 4782 St. Florian am Inn (AT)
(74) Vertreter: Schneider, Sascha

(56) Entgegenhaltungen:
- EP-A1- 3 367 423
- WO-A1-2016/119915
- WO-A1-2018/087420
- US-A1- 2009 111 279
- US-A1- 2011 014 457

## Beschreibung

Die Erfindung beschreibt ein Verfahren zur Herstellung eines Trägersubstrates zur Übertragung einer Übertragungsschicht von einem Trägersubstrat auf ein Produktsubstrat. Die Übertragungsschicht, insbesondere eine Graphenschicht, ist dabei zunächst auf dem Trägersubstrat angeordnet, insbesondere wurde die Übertragungsschicht auf einer Schicht des Trägersubstrates erzeugt beziehungsweise gezüchtet, und wird mit dem Verfahren zur Übertragung auf das Produktsubstrat übertragen.

Im Stand der Technik existieren bereits Schichtübertragungsprozesse (eng.: layer transfer processes). Diese Prozesse werden verwendet um sehr dünne Schichten, insbesondere solche mit Dicken im Mikrometer oder sogar Nanometerbereich, von einem Substrat auf ein anderes Substrat, zu übertragen. Sehr viele dieser Schicht lassen sich nur auf einer spezifischen ersten Oberfläche erzeugen, die aber nicht gleichzeitig Teil des späteren funktionalen Bauteils sein soll. Daher muss die Schicht von der ersten Oberfläche auf eine zweite Oberfläche übertragen werden. Druckschrift WO2018087420A1 offenbart ein System zur chemischen Gasphasenabscheidung (CVD) mit einem rotierenden Bandsystem, bei dem mindestens ein Band als Substrat für das Wachstum einer Schicht dient.

Einer der bekanntesten Schichtübertragungsprozesse in der Halbleiterindustrie ist der SmartCut^{™} Prozess. In diesem Prozess werden Ionen, insbesondere Wasserstoffionen, in ein erstes, einkristallines Substrat geschossen. Die Eindringtiefe der Wasserstoffionen kann durch die kinetische Energie geregelt werden und beträgt nur einige Nanometer. Die Wasserstoffionen verbleiben im ersten Substrat, bis das Substrat zu einem zweiten, oxidierten Substrat gebondet wurde. Danach sorgt ein thermischer Prozess dafür, dass sich die Wasserstoffatome zu Wassermolekülen kombinieren und eine Trennung des ersten, einkristallinen Substrats entlang der Fläche, in der sich die Wasserstoffionen angesammelt haben, erfolgt. Man erhält eine Dreischichtenstruktur, bei der das Oxid zwischen zwei anderen Materialien, meistens Silizium eingeschlossen ist. Die übertragene Schicht des ersten Substrats ist dabei sehr dünn und vor allem einkristallin. Die darunter liegende Oxidschicht hat dann positive Auswirkungen auf Bauteile mit hohen Schaltfrequenzen, insbesondere Transistoren.

Seit einigen Jahren wird in der Industrie versucht, Graphen großflächig herzustellen. Im Stand der Technik existieren mehrere Verfahren zur Herstellung von Graphen. Graphenflocken können bereits im industriellen Tonnenmaßstab hergestellt werden. Diese Graphenflocken sind für die Halbleiterindustrie allerdings von untergeordneter Bedeutung, da sie viel zu klein sind und vorwiegend durch nasschemische Prozesse, insbesondere in Lösung, und nicht auf Substratoberflächen entstehen. Angestrebt wird die Herstellung einer Graphenschicht entweder auf Wafer Level, d.h. über die gesamte Fläche eines Wafers oder aber gezielt an einer bereits vorhandenen Topologie eines Wafers. Am Aussichtsreichsten scheint aber die Herstellung einer Graphenschicht auf Wafer Level zu sein.

Das größte Problem besteht dabei darin, Graphenschichten oder sonstige empfindliche zu übertragende Schichten kosteneffizient, schnell, großflächig und defektfrei herzustellen. Die Erfahrung hat gezeigt, dass die großflächige Züchtung von Graphenschichten vorzugsweise auf einer, insbesondere einkristallinen, Metalloberfläche erfolgt.

Das Problem besteht aber darin, dass die Oberflächen, auf denen Graphen großflächig gezüchtet werden soll, in den seltensten Fällen den Oberflächen entsprechen, auf denen das Graphen strukturiert und angewandt werden soll. Das Graphen muss daher von einer ersten Oberfläche, einer Herstelloberfläche, auf eine zweite Oberfläche, eine Nutzoberfläche, übertragen werden. Bei der Übertragung werden üblicherweise Debondmittel, insbesondere Laser, eingesetzt, deren Einflüsse, insbesondere elektromagnetische Strahlung, die Übertragungsschicht beziehungsweise die Graphenschicht zerstören oder beschädigen könnten.

Es ist daher Aufgabe der vorliegenden Erfindung ein Verfahren zur Herstellung eines Trägersubstrates aufzuzeigen, welche die im Stand der Technik aufgeführten Nachteile zumindest zum Teil beseitigen, insbesondere vollständig beseitigen. Insbesondere ist es eine Aufgabe der Erfindung ein Trägersubstrat Herstellungsverfahren aufzuzeigen, um eine Übertragungsschicht von dem Trägersubstrat auf ein Produktsubstrat zu übertragen.

Die vorliegende Aufgabe wird mit den Merkmalen des Anspruchs 1 gelöst. Vorteilhafte Weiterbildungen der Erfindung sind in den Unteransprüchen angegeben.

Im weiteren Verlauf des Textes wird unter einer Übertragungsschicht beziehungsweise einer zur übertragenden Schicht, insbesondere in Form einer Graphenschicht, diejenige Schicht des Trägersubstrates verstanden, die auf das Produktsubstrat übertragen werden soll. Insbesondere ist die Übertragungsschicht auf einer Schutzschicht beziehungsweise einer Wachstumsschicht des Trägersubstrates gezüchtet worden. Schutzschicht und Wachstumsschicht werden daher im weiteren Text synonym verwendet.

Bei der Wachstumsschicht und der Schutzschicht kann es sich allerdings um zwei unterschiedliche Schichten handeln. Die Wachstumsschicht steht dabei mit der Übertragungsschicht in Kontakt, so dass die Schutzschicht zwischen der Wachstumsschicht und dem Trägergrundsubstrat befindet. Im weiteren Verlauf des Textes wird der Einfachheit halber davon ausgegangen, dass Wachstumsschicht und Schutzschicht identisch sind. Dieser Zustand ist auch der wirtschaftlich sinnvollere, da in diesem Fall nur eine Schicht abgeschieden werden muss und dadurch die Prozesskosten geringer gehalten werden.

Demnach wird offenbart ein Trägersubstrat zum Übertragen einer Übertragungsschicht von dem Trägersubstrat auf ein Produktsubstrat, aufweisend zumindest die folgenden Schichten in der folgenden Reihenfolge:
- ein Trägergrundsubstrat,
- eine Schutzschicht und
- die Übertragungsschicht,
wobei die Übertragungsschicht auf der Schutzschicht gezüchtet ist.

Das Trägersubstrat weist zumindest die vorgenannten Schichten in der vorbezeichneten Reihenfolge auf. Denkbar ist jedoch auch, dass weitere zwischen gelagerte Schichten, insbesondere mit bestimmten Funktionen, zwischen und/oder auf den vorgenannten Schichten angeordnet sind. Insbesondere kann die Schutzschicht beispielsweise aus mehreren einzelnen Schichten bestehen, welche jeweils die Übertragungsschicht schützen. Die Schutzschicht wirkt dabei als Barriere zum Schutz der Übertragungsschicht, insbesondere vor Einflüssen, welche zum Übertragen wirken und die Übertragungsschicht beschädigen beziehungsweise zerstören könnten. Um die Übertragungsschicht von dem Trägersubstrat auf das Produktsubstrat zu übertragen, wird insbesondere die Hafteigenschaft im Bereich zwischen der Schutzschicht und der Übertragungsschicht herabgesetzt, wobei die Schutzschicht die zu übertragende Schicht abschirmt. Durch diesen Schichtaufbau des Trägersubstrates kann das Übertragen der Übertragungsschicht vorteilhaft einfach und effizient durchgeführt werden, wobei die Übertragungsschicht nicht beschädigt wird, da diese durch die Schutzschicht geschützt wird. Weiterhin wird durch die Doppelfunktion der Schutzschicht als Barriere und als Wachstumsschicht für die Übertragungsschicht eine kostengünstigere Herstellung im industriellen Maßstab ermöglicht.

Die Erfindung betrifft ein Verfahren zur Herstellung eines Trägersubstrates zum Übertragen einer Übertragungsschicht von dem Trägersubstrat auf ein Produktsubstrat mit den folgenden Schritten:
i) Bereitstellen eines Trägergrundsubstrates,
ii) Aufbringen einer Schutzschicht auf dem Trägergrundsubstrat,
iii) Züchten einer Übertragungsschicht, insbesondere einer

Graphenschicht, auf der Schutzschicht, wobei die Schutzschicht aus mehreren einzelnen Schichten besteht, dadurch gekennzeichnet, dass vor dem Aufbringen der Schutzschicht in Schritt ii) das Trägergrundsubstrat mit einer Löseschicht beschichtet wird, so dass die Schutzschicht auf der Löseschicht aufgebracht wird.

Das Verfahren zur Herstellung eines Trägersubstrates sieht vor, dass eine Übertragungsschicht auf einer Schutzschicht gezüchtet wird. Die Schutzschicht kann zum einen zum Schutz der Übertragungsschicht bei einem Übertragen der Übertragungsschicht dienen, als auch als der Ort der Erzeugung beziehungsweise Züchtung der Übertragungsschicht. Die Schutzschicht besitzt somit eine Doppelfunktion, so dass eine zusätzliche Schicht bei der Herstellung eingespart werden kann. Zudem wird durch das die Schutzschicht aufweisende Trägersubstrat eine spätere Übertragung ohne eine Beeinträchtigung der Übertragungsschicht möglich. Es wird somit vorteilhaft möglich den Ort der Erzeugung beziehungsweise Züchtung der Übertragungsschicht von der Verwendung auf dem Produktsubstrat einfach zu trennen.

Weiterhin wird offenbart ein Verfahren zum Übertragen einer Übertragungsschicht von dem Trägersubstrat oder einem Trägersubstrat hergestellt nach dem Verfahren zur Herstellung eines Trägersubstrates auf ein Produktsubstrat, wobei
- das Trägersubstrat mit dem Produktsubstrat kontaktiert wird, so dass die Übertragungsschicht dem Produktsubstrat zugewandt ist, und
- wobei mindestens ein Debondmittel auf das Trägersubstrat einwirkt, so dass die Übertragungsschicht zusammen mit der Schutzschicht von einem Trägergrundsubstrat abgelöst wird.

Das Verfahren zum Übertragen der Übertragungsschicht erlaubt somit vorteilhaft ein einfaches und effizientes Übertragen der Übertragungsschicht von einer Oberfläche auf eine andere Oberfläche, insbesondere das Übertragen von einer Herstellungsoberfläche auf eine Nutzungsoberfläche.

Das Ablösen wird durch das Wirken des mindestens einen Debondmittels, insbesondere in Form eines Lasers, vorzugsweise in Form eines Infrarotlasers, ermöglicht, wobei die Schutzschicht die Übertragungsschicht vor den Einflüssen des mindestens einen Debondmittels schützt beziehungsweise die Übertragungsschicht vor den Einflüssen abschirmt, sodass die Übertragungsschicht nicht beschädigt wird. Dabei ist insbesondere vorgesehen, dass die Übertragungsschicht zusammen mit der Schutzschicht von dem Trägersubstrat abgelöst wird und anschließend die Schutzschicht entfernt wird. Das Trägersubstrat wird mit dem Produktsubstrat kontaktiert, sodass vorteilhaft keine Relativbewegung zwischen den kontaktierten Flächen mehr möglich ist. Vor einer Kontaktierung werden das Trägersubstrat und das Produktsubstrat zueinander, insbesondere durch eine Ausrichtung von jeweiligen Substrathaltern, ausgerichtet. Zur Ausrichtung werden insbesondere Ausrichtungsmarken, welche auf dem Trägersubstrat und/oder dem Produktsubstrat angebracht sind, zur möglichst exakten Ausrichtung verwendet. Folglich wird die Übertragung einer Übertragungsschicht auf ein Produktsubstrat vorteilhaft einfach und effizient ermöglicht. Besonders vorteilhaft wird die Übertragungsschicht nicht durch das Wirken der Debondmittel beschädigt beziehungsweise nicht zerstört. Dabei ist das Erzeugen beziehungsweise Züchten der Übertragungsschicht zuvor auf dem Trägersubstrat durchgeführt worden. Somit kann nun vorteilhaft die Übertragungsschicht vom Ort ihrer Erzeugung beziehungsweise ihrer Züchtung auf dem Trägersubstrat, insbesondere auf der Schutzschicht, gelöst werden und auf dem Produktsubstrat angeordnet werden.

In einer bevorzugten Ausführungsform des Trägersubstrates ist vorgesehen, dass die Übertragungsschicht eine Graphenschicht ist. Die Graphenschicht ist dabei auf der Schutzschicht angeordnet und wird von der Schutzschicht geschützt. Da vorgesehen ist, dass das zum Übertragen der Graphenschicht ausgebildete Trägersubstrat beim Übertragen zusammen mit der Schutzschicht vom Trägergrundsubstrat debondet wird und somit die Graphenschicht vom Trägersubstrat getrennt wird, können die Mittel zum Debonden, insbesondere in Form von elektromagnetischer Strahlung, die Graphenschicht nicht beschädigen oder zerstören. Daher ist das Trägersubstrat prädestiniert für die Übertragung einer Graphenschicht. Das Trägersubstrat ermöglicht vorteilhaft das einfache und effiziente Herstellen und das Übertragen von Graphenschichten in großen Mengen, statt wie bisher nur im Labormaßstab. Ein besonderer Vorteil besteht darin, dass die Graphenschicht als Übertragungsschicht auf der Schutzschicht gezüchtet wird.

In einer anderen bevorzugten Ausführungsform des Trägersubstrates ist vorgesehen, dass eine Rauheit der Schutzschicht, insbesondere auf der der Übertragungsschicht zugewandten Oberfläche, kleiner als 100 µm, vorzugsweise kleiner als 10 µm,noch bevorzugter kleiner als 1 µm, am bevorzugtesten kleiner als 100nm, am allerbevorzugtesten kleiner als 10nm ist. Dadurch das die Rauheit der Wachstumsschicht möglichst gering zu gehalten wird, wird die Erzeugung beziehungsweise die Züchtung der Übertragungsschicht insbesondere überhaupt erst zu ermöglicht. Besonders dünne Übertragungsschichten, insbesondere Graphenschichten, müssen auf sehr ebenen, reinen Oberflächen gezüchtet werden. Die Übertragungsschicht wird somit auf der Schicht erzeugt, von welcher diese auch vor den Einflüssen von den beim Übertragen wirkenden Debondmitteln geschützt wird. Bevorzugt wird die Schutzschicht bei ihrer Herstellung vor dem Züchten der Übertragungsschicht rekristallisiert, wodurch die Züchtung der Übertragungsschicht, insbesondere der Graphenschicht, zusätzlich vereinfacht beziehungsweise verbessert wird.

In einer anderen bevorzugten Ausführungsform des Trägersubstrates ist vorgesehen, dass das Trägersubstrat mindestens eine zwischen dem Trägergrundsubstrat und der Schutzschicht angeordnete Löseschicht aufweist. Die Löseschicht kann vorteilhaft den genauen Ort der Loslösung der Übertragungsschicht an dem Trägergrundsubstrat vorgeben. Weiterhin kann ein Lösen entlang der Löseschicht vorteilhaft einfach und effizient erfolgen.

Durch die Ausgestaltung der Löseschicht kann zudem vorteilhaft die notwendige Adhäsionskraft zwischen dem Trägergrundsubstrat und der Schutzschicht vorgegeben werden. Insbesondere kann durch die Auslegung der Löseschicht vorgegeben werden, unter welchen Einflüssen ein Lösen der Übertragungsschicht möglich sein soll.

In einer anderen bevorzugten Ausführungsform des Trägersubstrates ist vorgesehen, dass die Übertragungsschicht durch ein auf die Löseschicht und/oder auf einen Lösebereich einwirkendes Debondmittel von dem Trägergrundsubstrat zusammen mit der Schutzschicht ablösbar ist. Das oder die Debondmittel wirken auf das Trägersubstrat, wenn ein Debondvorgang durchgeführt werden soll. Dabei sind Löseschicht beziehungsweise Lösebereich und das Debondmittel aufeinander abgestimmt. Eine Löseschicht ist dabei eine eigene Schicht aus Material, wohingegen ein Lösebereich durch die Kontaktfläche zwischen Trägergrundsubstrat und Schutzschicht vorgegeben ist. Ein Lösen in dem Lösebereich kann beispielsweise durch Ausdehnung von in die kontaktieren Oberflächenbereiche eingebrachte Materialien erfolgen. Daher stellt ein Lösebereich keine eigene Schicht des Trägersubstrates dar, erfüllt jedoch insbesondere dieselbe Funktion. Wenn das Debondmittel auf den Lösebereich beziehungsweise auf die Löseschicht wirkt, ändern sich insbesondere die Hafteigenschaften der Löseschicht beziehungsweise die Hafteigenschaften der in Kontakt stehenden Schutzschicht und des Trägergrundsubstrates, so dass die Schutzschicht zusammen mit der Übertragungsschicht von dem Trägergrundsubstrat abgelöst werden kann. Somit lässt sich ein Übertragen der Übertragungsschicht von dem Trägersubstrat auf ein Produktsubstrat besonders einfach und effizient durchführen.

In einer anderen bevorzugten Ausführungsform des Trägersubstrates ist vorgesehen, dass die Schutzschicht aus einem Material mit einer Löslichkeit für Kohlenstoff ist. Handelt es sich bei der Schutzschicht um ein Material mit einer insbesondere hohen Löslichkeit für Kohlenstoff, kann die Übertragungsschicht, insbesondere aus Graphen, durch Erwärmen und Abkühlen auf der Schutzschicht erzeugt beziehungsweise gezüchtet werden. Dabei wird der Kohlenstoff auf der Oberfläche der Schutzschicht abgeschieden und die Übertragungsschicht auf dem Trägersubstart hergestellt. Durch den besonderen und vorteilhaften Schichtaufbau des Trägersubstrates kann nunmehr die erzeugte Übertragungsschicht einfach und effizient auf ein Produktsubstrat übertragen werden.

In einer anderen bevorzugten Ausführungsform des Trägersubstrates ist vorgesehen, dass die Schutzschicht für elektromagnetische Strahlung undurchlässig ausgebildet ist. Wird elektromagnetische Strahlung zum Debonden beziehungsweise zum Verringern der Hafteigenschaften der Löseschicht verwendet, beispielsweise ein Laser, kann die Schutzschicht die Strahlung absorbieren und somit eine Beschädigung beziehungsweise eine Zerstörung der Übertragungsschicht verhindert werden. In dieser Ausführungsform ist das Trägergrundsubstrat vorzugsweise zumindest teildurchlässig für elektromagnetische Strahlung. Beispielsweise ist das Trägergrundsubstrat aus Glas, vorzugsweise aus Saphirglas.

In einer anderen bevorzugten Ausführungsform des Trägersubstrates ist vorgesehen, dass auf der Schutzschicht abgewandten Seite der Übertragungsschicht eine Kontaktschicht, insbesondere aus dielektrischem Material, vorzugsweise aus Siliziumoxid, angeordnet ist. Eine solche Kontaktschicht ermöglicht bei der Übertragung auf das Produktsubstrat eine einfachere und sichere Kontaktierung. Zudem können durch das Verwenden eines dielektrischen Materials, beispielsweise Siliziumoxid, für die Kontaktschicht Kurzschlüsse im Produktsubstrat verhindert werden beziehungsweise eine elektrische Leitung zwischen Produktsubstrat und Übertragungsschicht nur an gewünschten Stellen zugelassen werden. Eine weitere Kontaktschicht kann ebenfalls auf dem Produktsubstrat angeordnet werden. Die Kontaktschicht und die weitere Kontaktschicht des Produktsubstrates sind vorzugsweise aus demselben Material und ermöglichen eine besonders einfach Kontaktierung zwischen Trägersubstrat und Produktsub strat.

In einer anderen bevorzugten Ausführungsform des Trägersubstrates ist vorgesehen, dass die Schutzschicht eine einkristalline Metallschicht, vorzugsweise aus Nickel, ist. Das Erzeugen beziehungsweise das Züchten der Übertragungsschicht erfolgt vorteilhaft auf einem monokristallinen Material. Bei der Verwendung einer einkristallinen Metallschicht kann vorteilhaft die Übertragungsschicht auf der Schutzschicht gezüchtet werden. Gleichzeitig eignen sich die einkristallinen Metallschichten ebenfalls zum Schutz der Übertragungsschicht gegenüber den Einflüssen eines elektromagnetischen Debondmittels, beispielsweise eines Lasers. Am bevorzugtesten ist die Schutzschicht aus Nickel, da sich eine Graphenschicht besonders gut auf einer solchen Nickelbasisschicht erzeugt beziehungsweise gezüchtet werden kann.

In einer anderen bevorzugten Ausführungsform des Trägersubstrates ist vorgesehen, dass auf der Schutzschicht die Übertragungsschicht erzeugt wird. Gemäß dieser Ausführungsform wird die zu übertragende Schicht direkt auf der Schutzschicht erzeugt. Die Übertragungsschicht ist somit vorteilhaft direkt auf der Schutzschicht angeordnet, sodass die Übertragungsschicht unmittelbar von der Schutzschicht gegenüber von der anderen Seit der Schutzschicht wirkenden Einflüssen geschützt ist. Der besondere Schichtaufbau des Trägersubstrates ermöglich die einfache und effiziente Übertragung der Übertragungsschicht von dem Trägersubstrat auf das Produktsub strat.

In einer anderen bevorzugten Ausführungsform des Trägersubstrates ist vorgesehen, dass die Schutzschicht gleichzeitig als Wachstumsschicht für die Übertragungsschicht ausgebildet ist, so dass die Übertragungsschicht auf der Schutzschicht züchtbar ist. In der Ausführungsform erfüllt die Schutzschicht zwei Funktionen. Die erste Funktion ist die Schutzfunktion der Schutzschicht, das bedeutet insbesondere, dass die Schutzschicht die Übertragungsschicht vor den Einflüssen der Debondmittel schützt. Die zweite Funktion ermöglicht das Züchten einer Übertragungsschicht auf der Schutzschicht, welche in diesem Falle gleichzeitig als Wachstumsschicht verwendbar ist. Auf diese Weise ist vorteilhaft nur eine Schicht zum Schutz und zum Erzeugen der Übertragungsschicht, insbesondere der Graphenschicht, notwendig. Denkbar ist auch, dass die Schutzschicht aus mehreren Schichten ausgebildet ist. Die der Löseschicht zugewandte Schicht oder Schichten sind dabei als Schutzschichten ausgebildet. Die der Löseschicht abgewandte Schicht oder Schichten ermöglich das Erzeugen einer Übertragungsschicht. Die Doppelfunktion der Schutzschicht wird also durch zwei oder mehr Schichten erreicht, wobei die Schutzschicht aus mindestens zwei Schichten besteht. Bevorzugt ist jedoch, eine Schicht die Schutzschicht bildet, welche gleichzeitig die Schutzfunktion und das Erzeugen der Übertragungsschicht ermöglicht.

In einer anderen bevorzugten Ausführungsform des Trägersubstrates ist vorgesehen, dass die Übertragungsschicht durch mindestens ein auf die Löseschicht beziehungsweise auf einen Lösebereich einwirkendes Debondmittel von dem Trägergrundsubstrat zusammen mit der Schutzschicht ablösbar ist. Das Debondmittel, vorzugsweise in Form eines Lasers, wirkt auf die Löseschicht ein, sodass die Hafteigenschaften der Löseschicht herabgesetzt werden und die Übertragungsschicht zusammen mit der Schutzschicht vom Trägersubstrat ablösbar ist. Das Debondmittel wirkt dabei bevorzugt auf die Löseschicht. Weitere vom Debondmittel ausgehende Einflüsse werden durch die Schutzschicht reduziert, bevorzugt verhindert. Die Schutzschicht wirkt dabei für die Übertragungsschicht vorzugsweise als Barriere gegenüber der vom Debondmittel ausgehenden Einflüsse. Auf diese Weise kann vorteilhaft ein Debonden der Übertragungsschicht durchgeführt werden, ohne die Übertragungsschicht zu beschädigen.

In einer bevorzugten Ausführungsform des Verfahrens zur Herstellung eines Trägersubstrates ist vorgesehen, dass vor dem Züchten der Übertragungsschicht in Schritt iii) die Schutzschicht rekristallisiert wird. Auf der vorzugsweise eine sehr geringe Rauheit aufweisende Schutzschicht, kann somit noch besser ihre Funktion als Wachstumsschicht erfüllen. Die Züchtung der Übertragungsschicht, insbesondere einer Graphenschicht, auf der Schutzschicht wird somit vereinfacht beziehungsweise verbessert.

Gemäß dem erfinderischen Verfahren zur Herstellung eines Trägersubstrates ist vorgesehen, dass vor dem Aufbringen der Schutzschicht in Schritt ii) das Trägergrundsubstrat mit einer Löseschicht beschichtet wird, so dass die Schutzschicht auf der Löseschicht aufgebracht wird. Auf diese Weise kann bei einem späteren Übertragen der erzeugten Übertragungsschicht ein Lösen vorteilhaft einfach durchgeführt werden. Zudem kann durch das Aufbringen einer Löseschicht vorteilhaft der Ort des Loslösens vorgegeben werden.

In einer bevorzugten Ausführungsform des Verfahrens zur Herstellung eines Trägersubstrates ist vorgesehen, dass auf der Übertragungsschicht auf der der Schutzschicht abgewandten Seite eine Kontaktschicht abgeschieden wird. Die Kontaktschicht vereinfacht vorteilhaft den bei dem Übertragen der Übertragungsschicht durchgeführten Bondvorgang. Weiterhin kann die Kontaktschicht ebenfalls einer besseren Kontaktierung an das Produktsubstrat dienlich sein. Weiterhin kann mittels einer funktionalisierten Kontaktschicht, beispielsweise mittels elektrisch leitender Bereiche ein Kontakt zu der Übertragungsschicht in bestimmten vorgegebenen Bereichen ermöglicht werden.

In einer bevorzugten Ausführungsform des Verfahrens zur Herstellung eines Trägersubstrates ist vorgesehen, dass die Schutzschicht gleichzeitig als Wachstumsschicht für ein Züchten der Übertragungsschicht auf der Schutzschicht ausgebildet ist und die Übertragungsschicht auf der Schutzschicht gezüchtet wird. Die Schutzschicht erfüllt somit vorteilhaft die Schutzfunktion und ermöglicht das Erzeugen der Übertragungsschicht auf der Schutzschicht. Es wird daher vorteilhaft nur eine Schicht verwendet. Denkbar wäre jedoch auch, dass die Schutzschicht aus zwei oder mehr Schichten aufgebaut wird. Die der Löseschicht zugewandten Schichten beziehungsweise die der Löseschicht zugewandte Schicht ist dann für den Schutz gegenüber der Einflüsse der Debondmittel ausgebildet. Die weitere Schicht oder weitere Schichten ermöglichen als Wachstumsschicht das Erzeugen der Übertragungsschicht. Bevorzugt ist jedoch, dass die Schutzschicht aus einer Schicht mit Doppelfunktion ausgebildet ist. Auf diese Weise ist das Verfahren zur Herstellung eines Trägersubstrates vorteilhaft einfach und effizient möglich.

In einer anderen bevorzugten Ausführungsform des Verfahrens zur Herstellung eines Trägersubstrates ist vorgesehen, dass auf der Übertragungsschicht eine Kontaktschicht abgeschieden wird. Die Kontaktschicht ist vorzugsweise aus einem dielektrischen Material, besonders bevorzugt aus Siliziumoxid. Dadurch können später Kurzschlüsse im Produktsubstrat verhindert werden. Weiterhin kann ein Kontaktieren des Trägersubstrates mit dem Produktsubstrat besonders einfach und sicher durchgeführt werden,

In einer bevorzugten Ausführungsform des Verfahrens zum Übertragen einer Übertragungsschicht ist vorgesehen, dass das Trägersubstrat mit dem Produktsubstrat über eine an der Übertragungsschicht aufgebrachten Kontaktschicht kontaktiert wird oder das Trägersubstrat mit einer auf dem Produktgrundsubstrat aufgebrachten weiteren Kontaktschicht des Produktsubstrats über eine an der Übertragungsschicht aufgebrachten Kontaktschicht kontaktiert wird. Das Produktsubstrat weist somit eine weitere Kontaktschicht auf. Die Kontaktschicht ist vorzugsweise aus einem dielektrischem Material, besonders bevorzugt aus Siliziumoxid. Wenn das Trägersubstrat auf der Übertragungsschicht ebenfalls eine Kontaktschicht aufweist, sind die Kontaktschicht des Trägersubstrates und die weitere Kontaktschicht des Produktsubstrates besonders bevorzugt aus demselben Material. Eine Kontaktierung bei der Übertragung kann somit besonders einfach und effizient erfolgen. Zudem werden Kurzschlüsse durch Kontaktschichten verhindert.

In einer anderen bevorzugten Ausführungsform des Verfahrens zum Übertragen einer Übertragungsschicht ist vorgesehen, dass die Übertragungsschicht mit dem Produktsubstrat verbondet wird oder eine auf der Übertragungsschicht angeordnete Kontaktschicht mit dem Produktsubstrat verbondet wird. Die Übertragungsschicht wird mit dem Produktsubstrat verbondet, wodurch die Übertragung abgeschlossen wird.

Der Bondvorgang teilt sich vorzugsweise in einen Pre-Bond und einen anschließenden Permanentbond ein. Beim Pre-Bond wird eine relative schwache, theoretisch wieder ohne Zerstörung lösbare Verbindung zwischen den beiden Substraten erzeugt, die vorzugsweise auf Oberflächeneffekten beruht. Insbesondere sind in diesem Fall hydrophile Oberflächen von Vorteil. Der spätere Permanentbond zeichnet sich durch eine Verstärkung der im Pre-Bond erzeugten Verbindungen aus. Vorzugsweise wird der Permanentbond durch eine erhöhte Temperatur erreicht. Die Temperatur sollte aber möglichst gering sein, um mögliche Schädigungen an der Übertragungsschicht oder an möglichen vorhandenen Anlagenteilen zu reduzieren bzw. vorzugsweise gänzlich zu verhindern. Die Temperatur beim Permanentbonden ist daher vorzugsweise kleiner als 300°C, vorzugsweise kleiner als 200°C, noch bevorzugter kleiner als 100°C, am bevorzugtesten kleiner als 50°C, am allerbevorzugtesten Raumtemperatur. Dem Fachmann auf dem Gebiet sind derartige Pre-Bonds und Permanentbonds bekannt.

Die Schutzschicht wird insbesondere vor, während oder nach den Verbonden der Übertragungsschicht und dem Produktsubstrat von der Übertragungsschicht gelöst. Durch das Verfahren kann ein Übertragen einer defektfreien, großflächigen und empfindlichen Übertragungsschicht besonders einfach und effizient erfolgen. Besonders bevorzugt ist das Übertragen einer Graphenschicht auf das Produktsubstrat. In das Produktsubstrat selbst können zuvor funktionale Bauteile integriert worden sein, insbesondere können Durchkontaktierungen vorhanden sein, sodass nur in diesen Bereichen eine gezielten und gewünschte elektrische Leitfähigkeit zwischen dem Produktsubstrat und der Übertragungsschicht möglich ist.

Im Folgenden wird der Begriff Wachstumsschicht für Schutzschicht verwendet. Da in den aller meisten Fällen die Schutzschicht zum Schutz und zum Erzeugen beziehungsweise Züchten der Übertragungsschicht ausgebildet ist, werden die Begriffe Wachstumsschicht und Schutzschicht im Folgenden als Wachstumsschicht bezeichnet. Gemeint ist jedoch nicht nur eine einzelne Wachstumsschicht ohne Schutzfunktion, vielmehr ist eine Wachstumsschicht eine Schutzschicht auf welcher eine Übertragungsschicht gezüchtet beziehungsweise erzeugt werden kann.

Ein besonderer Aspekt des Erfindungsgedankens beinhaltet ein Verfahren aufzuzeigen, mit dem die Züchtung beziehungsweise Erzeugung, die Übertragung und der Debond einer einzelnen zu übertragenden Schicht beziehungsweise einer Graphenschicht von einer Herstelloberfläche eines Trägersubstrats auf eine Nutzoberfläche eines Produktsubstrats durchgeführt werden kann. Der grundlegende Gedanke besteht dabei darin, ein Schichtsystem, bestehend aus einem Trägergrundsubstrat, einer Löseschicht, einer Wachstumsschicht, der Graphenschicht (Übertragungsschicht) und vorzugsweise einer dielektrischen Schicht in einer wohldefinierten Reihenfolge herzustellen, sodass die Schichtübertragung problemlos durchgeführt werden kann.

Ein weiterer Aspekt der Erfindung sieht vor einen sehr speziellen Schichtaufbau auf einem Trägersubstrat zu erzeugen, dessen einzelne Schichten unterschiedliche funktionale Aufgaben erfüllen. Insbesondere wird eine Löseschicht zur Trennung der Graphenschicht vom Trägersubstrat verwendet. Eine Wachstumsschicht beziehungsweise Schutzschicht dient der Züchtung und gleichzeitig auch dem Schutz der Übertragungsschicht beziehungsweise der Graphenschicht.

Das Trägergrundsubstrat, auf dem die zu übertragende Schicht beziehungsweise das Graphen hergestellt werden kann, unterscheidet sich im Allgemeinen vom Produktgrundsubstratsubstrat, auf dem die zu übertragende Schicht beziehungsweise das Graphen verwendet werden soll. Dadurch wird der Prozess der Herstellung der Übertragungsschicht beziehungsweise der Graphenzüchtung vom Ort der Verwendung der Übertragungsschicht beziehungsweise der Graphenverwendung getrennt. Entsprechend flexibel und kosteneffizient ist die Erzeugung einer solchen empfindlichen Übertragungsschicht beziehungsweise Graphenschicht.

Das Trägersubstrat und das Verfahren zur Übertragung einer Übertragungsschicht kann grundsätzlich für die Übertragung einer jeden Art von zu übertragenden Schicht beziehungsweise Übertragungsschicht genutzt werden. Exemplarisch wird allerdings die Übertragung einer Graphenschicht als Übertragungsschicht beschrieben, da eine Übertragung einer solchen monoatomaren Schicht besondere Voraussetzungen erfüllen muss und in der Industrie bis heute auf diese Art und Weise noch nicht umgesetzt werden konnte.

Das erfindungsgemäße Verfahren ist aber in keiner Weise auf die Übertragung einer Graphenschicht eingeschränkt. Beispielsweise kann es sich bei der Übertragungsschicht auch um eine andere kohlenstoffbasierte, insbesondere monoatomare Schicht, handeln.

Die Übertragungsschicht besteht vorzugsweise zumindest aus einer der folgenden Materialklassen bzw. Materialien.
- 2D Schichtmaterial, insbesondere
   ∘ Graphen
   ∘ Graphyne
   ∘ Borophene
   ∘ Germanene
   ∘ Silicene
   ∘ Si₂BN
   ∘ Gallenene
   ∘ Stanene
   ∘ Plumbene
   ∘ Phosphorene
   ∘ Antimonene
   ∘ Bismuthene
- 2D Suprakristalle
- Verbindungen
   ∘ Graphane
   ∘ Boronitren
   ∘ Borocarbonitride
   ∘ Germanane
   ∘ Germaniumphosphid
   ∘ Übergangsmetaldichalcogenide
   ∘ MXenes
- Lagenmaterialien mit unterschiedlicher Elementzusammensetzung, insbesondere
   ∘MoS2, WS2, MoSe2, hBN, Ti4N3, Ti4AlN3
- Van der Waals Hetereostrukturen, insbesondere
   ∘ MoS2-G; MoS2-hBN, MoS2-hBN-G
- Metall, insbesondere
   ∘ Cu, Ag, Au, Al, Fe, Ni, Co, Pt, W, Cr, Pb, Ti, Ta, Zn, Sn
- Halbleiter, insbesondere
   ∘ Ge, Si, Alpha-Sn, B, Se, Te,
- Verbindungshalbleiter, insbesondere
   ∘ GaAs, GaN, InP, InxGa1-xN, InSb, InAs, GaSb, AlN, InN, GaP, BeTe, ZnO, CuInGaSe2, ZnS, ZnSe, ZnTe, CdS, CdSe, CdTe, Hg(1-x)Cd(x)Te, BeSe, HgS, AlxGa1-xAs, GaS, GaSe, GaTe, InS, InSe, InTe, CuInSe2, CuInS2, CuInGaS2, SiC, SiGe
- Keramik
- Polymer
- Weitere Materialien
   ∘ SiO₂
   ∘ Si3N4
   ∘ MnO₂
   ∘ TBAₓH_{(1.07-x)}Ti_{1.73}O₄*H2O
   ∘ CoO₂⁻
   ∘ TBAₓH₍₁₋ₓ₎Ca₂Nb₃O₁₀
   ∘ Bi₂SrTa₂O₉
   ∘ CS₄W₁₁O₃₆²⁻
   ∘ Ni(OH)_{5/3}DS_{1/3}
   ∘ Eu(OH)_{2.5}(DS)_{0.5}
   ∘ Co_{2/3}Fe_{1/3}(OH)₂^{1/3+}
   ∘ [Cu₂Br(IN₂)]ₙ]

Am bevorzugtesten handelt es sich bei der Übertragungsschicht um eine Schicht aus Graphen.

Das Verfahren zum Übertragen der Übertragungsschicht benötigt insbesondere ein Produktsubstrat und ein Trägersubstrat. Produktsubstrat und Trägersubstrat bestehen im Allgemeinen aus einem Produktgrundsubstrat und einem Trägergrundsubstrat. Auf dem Produktgrundsubstrat und/oder dem Trägergrundsubstrat können im Allgemeinen mehrere Schichten abgeschieden werden.

Das Produktgrundsubstrat und das Trägergrundsubstrat können grundsätzlich aus jedem beliebigen Material bestehen, gehören aber vorzugsweise zu einer der folgenden Materialklassen:
1. Halbleitermaterial, insbesondere
   1.1 Ge, Si, Alpha-Sn, B, Se, Te,
2. Metall, insbesondere
   2.1 Cu, Ag, Au, Al, Fe, Ni, Co, Pt, W, Cr, Pb, Ti, Ta, Zn, Sn,
3. Verbindungshalbleiter, insbesondere
   3.1 GaAs, GaN, InP, InxGa1-xN, InSb, InAs, GaSb, AlN, InN, GaP, BeTe, ZnO, CuInGaSe2, ZnS, ZnSe, ZnTe, CdS, CdSe, CdTe, Hg(1-x)Cd(x)Te, BeSe, HgS, AlxGa1-xAs, GaS, GaSe, GaTe, InS, InSe, InTe, CuInSe2, CuInS2, CuInGaS2, SiC, SiGe,
4. Glas, insbesondere
   4.1. Metallische Gläser
   4.2. Nichtmetallische Gläser, insbesondere
      4.2.1 Organische nichtmetallische Gläser
      4.2.2 Anorganische nichtmetallische Gläser, insbesondere
         4.2.2.1 Nichtoxidische Gläser, insbesondere
            4.2.2.1.1 Halogenidgläser
            4.2.2.1.2 Chalkogenidgläser
         4.2.2.2 Oxidische Gläser, insbesondere
            4.2.2.2.1 Phosphatische Gläser
            4.2.2.2.2 Silikatische Gläser, insbesondere
               4.2.2.2.2.1 Alumosilikatgläser
               4.2.2.2.2.2 Bleisilikatgläser
               4.2.2.2.2.3 Alkali-Silikatgläser, insbesondere
                  4.2.2.2.2.3.1 Alkali-Erdalkalisilikatgläser
               4.2.2.2.2.4 Borosilikatgläser
               4.2.2.2.2.5 Quarzglas
            4.2.2.2.3 Boratgläser, insbesondere
               4.2.2.2.3.1 Alkaliboratgläser
   4.3. Materialien, die als Gläser bezeichnet werden aber keine sind
      4.3.1 Saphirglas.
Die Substrate werden im Folgenden näher beschrieben.

### Produktsubstrat

In einer **ersten Ausführungsform** besteht das Produktsubstrat nur aus dem Produktgrundsubstrat. Es weist daher keinerlei Beschichtung auf. Ein Produktgrundsubstrat ohne Schichten kann insbesondere als Ausgangslage für eine übertragene Graphenschicht dienen, die dann als Leitungsschicht strukturiert werden soll. Zu dieser Leitungsschicht kann danach ein weiteres Substrat gebondet werden. Denkbar wäre auch die Bestückung mit einzelnen Chips. Das bevorzugteste Produktgrundsubstrat ist ein Wafer, insbesondere ein Siliziumwafer.

In einer **zweiten Ausführungsform** befindet sich eine Schicht auf dem Produktgrundsubstrat, die im Weiteren als Kontaktschicht bezeichnet wird. Bei der Kontaktschicht handelt es sich vorzugsweise um eine dielektrische Schicht, am bevorzugtesten um eine Siliziumoxidschicht. Die Schicht wird Kontaktschicht genannt, da sie mit der zu übertragenden Übertragungsschicht, insbesondere einer Graphenschicht, oder einer darauf abgeschiedenen Schicht in einem späteren Prozessschritt kontaktiert wird. Die Kontaktschicht ist vorzugsweise eine dielektrische Schicht, am bevorzugtesten ein Oxid, am allerbevorzugtesten ein Siliziumoxid. Das Oxid kann thermisch erzeugt werden oder in einer Sauerstoffatmosphäre nativ wachsen. Eine solche dielektrische Schicht kann den Übertragungsprozess der Übertragungsschicht beziehungsweise der Graphenschicht erleichtern beziehungsweise kann für das angestrebte Endresultat notwendig sein.

In einer **dritten Ausführungsform** wurden zuvor im Produktgrundsubstrat funktionale Einheiten, insbesondere Mikrochips, Speicher, MEMs, LEDs etc. hergestellt. In einer ganz besonders bevorzugten erweiterten Ausführungsform wird das Produktgrundsubstrat nach der Herstellung der, insbesondere funktionalen, Einheiten mit einer Kontaktschicht beschichtet. In weiteren Prozessschritten wird die dielektrische Kontaktschicht dann oberhalb von Kontakten der funktionalen Einheiten, insbesondere lithographisch, geöffnet. Die so entstehenden Öffnungen können in weiteren Prozessschritten dann mit einem Elektrikum, insbesondere einem Metall, gefüllt werden. Diese Durchkontaktierungen werden in der Halbleiterindustrie als TSVs (engl.: through silicon vias) bezeichnet. Dadurch wird die Kontaktschicht zu einer Hybridschicht. Die Durchkontaktierungen stellen die elektrischen Bereiche, die sie umgebende dielektrische Schicht die dielektrischen Bereiche dar. In späteren Prozessschritten wird dann die Übertragungsschicht beziehungsweise die Graphenschicht auf die Kontaktschicht übertragen und somit ein Kontakt zwischen dem Graphen und den funktionalen Einheiten über die TSVs hergestellt. Denkbar ist auch, dass auf die Kontaktschicht verzichtet wird und man nur das Produktgrundsubstrat mit den funktionalen Einheiten verwendet um die Übertragungsschicht darauf zu übertragen.

Durch eine Kontaktschicht wird es möglich, ein Material mit gewissen Eigenschaften zu wählen, die das Produktsubstrat selbst nicht besitzt. Beispielsweise stellt Silizium einen intrinsischen Halbleiter dar und besitzt daher auch bei Raumtemperatur eine, wenn auch nur eine sehr geringe, Leitfähigkeit. Die Oberfläche, auf welche die Übertragungsschicht beziehungsweise die Graphenschicht übertragen wird, sollte in vielen Fällen dielektrisch sein, um einen Kurzschluss nach der Strukturierung des Material der Übertragungsschicht Graphens zu verhindern. Da Silizium mit bekannten Methoden oxidiert werden kann, ist ein Siliziumoxid ein bevorzugtes Material für eine dielektrische Schicht.

Auf eines der genannten Produktsubstrate kann mit Hilfe des Verfahrens dann eine Übertragungsschicht, beispielsweise eine Graphenschicht, übertragen werden, die danach strukturiert werden kann. Insbesondere wird die Übertragungsschicht so strukturiert, dass diese leitende Kontakte der funktionalen Einheiten, insbesondere über die TSVs, entsprechend verbindet.

Vorzugsweise handelt es sich bei einem Produktgrundsubstrat um einen Wafer, besonders bevorzugt um einen Siliziumwafer.

### Trägersubstrat

Das Trägersubstrat besteht mindestens aus einem Trägergrundsubstrat, einer Wachstumsschicht und der darauf angeordneten Übertragungsschicht, insbesondere der zuvor erzeugten Graphenschicht. Auf dem Trägersubstrat werden die Schichten in einer speziellen Reihenfolge ausgebracht. Die genannten Schichten sind notwendigerweise in der genannten Reihenfolge aufzubringen. Denkbar wäre allerdings, dass sich zwischen den genannten Schichten weitere Schichten befinden, die insbesondere anderen Zwecken dienen. Insbesondere kann eine Löseschicht zwischen dem Trägergrundsubstrat und der Schutzschicht angeordnet sein.

In einer **ersten Ausführungsform** besteht das Trägersubstrat aus mindestens einem Trägergrundsubstrat, einer darauf abgeschiedenen Löseschicht, einer auf der Löseschicht erzeugten Wachstumsschicht und der darauf angeordneten Übertragungsschicht, insbesondere in Form einer darauf erzeugten Graphenschicht.

Die erste Schicht ist eine Löseschicht, deren Aufgabe darin besteht, das Trägergrundsubstrat in einem Debondprozess von den anderen Schichten trennen zu können.

Die zweite Schicht ist eine Wachstumsschicht, auf der die Übertragungsschicht angeordnet ist beziehungsweise die Graphenschicht erzeugt bzw. gezüchtet werden soll. Die Wachstumsschicht kann grundsätzlich jede beliebige Morphologie und Kornstruktur aufweisen, ist allerdings vorzugsweise einkristallin. Die Wachstumsschicht ist vorzugsweise eine Metallschicht, in einer ganz besonders bevorzugten Ausführungsform eine Metallschicht mit einer Löslichkeit für Kohlenstoff. Die Löslichkeit für Kohlenstoff sollte vorzugsweise mit sinkender Temperatur abnehmen, sodass Ausscheidungen, insbesondere an der Oberfläche der Wachstumsschicht ermöglicht werden.

Ein besonders bevorzugtes vorteilhaftes charakteristisches Merkmal der Wachstumsschicht beziehungsweise der Schutzschicht besteht darin, dass sie als Barriere für die anzuwendende Debondmethode wirkt. Sie verhindert oder reduziert zumindest den Durchgang der Einflüsse, die zwar für den Debondvorgang an der Löseschicht benötigt werden, aber die nicht auf die Übertragungsschicht beziehungsweise die Graphenschicht wirken sollen. Dazu zählen Temperatureintrag, insbesondere aber die Einwirkung von elektromagnetischer Strahlung, insbesondere Laserstrahlung. Die Wachstumsschicht wirkt daher nicht nur als Ort der Graphenzüchtung, sondern als Barriere zwischen der Graphenschicht und dem Ort des Debondprozesses, der an der Löseschicht stattfindet. Das Merkmal der Schutzschicht besteht insbesondere darin, dass sie in Bezug zum verwendeten Debondverfahren so konzipiert wird, dass einerseits die Erzeugung der Übertragungsschicht erfolgen kann, diese Übertragungsschicht aber gleichzeitig durch die Schutzschicht vor einem zu starken Einfluss des Debondverfahrens geschützt wird.

Die Schutzschicht beziehungsweise die Wachstumsschicht weist zudem eine möglichst geringe Rauheit auf. Die Rauheit wird entweder als mittlere Rauheit, quadratische Rauheit oder als gemittelte Rauhtiefe angegeben. Die ermittelten Werte für die mittlere Rauheit, die quadratische Rauheit und die gemittelte Rauhtiefe unterscheiden sich im Allgemeinen für dieselbe Messstrecke bzw. Messfläche, liegen aber im gleichen Größenordnungsbereich. Daher sind die folgenden Zahlenwertebereiche für die Rauheit entweder als Werte für die mittlere Rauheit, die quadratische Rauheit oder für die gemittelte Rauhtiefe zu verstehen. Die Rauheit der Wachstumsschicht ist dabei kleiner als 100 µm,vorzugsweise kleiner als 10 µm,noch bevorzugter kleiner als 1 µm, am bevorzugtesten kleiner als 100nm, am allerbevorzugtesten kleiner als 10nm.

Die Rauheit der Löseschicht ist ebenfalls so gering wie möglich, insbesondere um die Rauheit der, auf der Löseschicht gebildeten, Wachstumsschicht, möglichst gering zu halten. Die Rauheit der Löseschicht ist dabei kleiner als 100 µm,vorzugsweise kleiner als 10 µm, noch bevorzugter kleiner als 1 µm, am bevorzugtesten kleiner als 100nm, am allerbevorzugtesten kleiner als 10nm. Die Löseschicht kann grundsätzlich aus jedem Material bestehen, welches mit Hilfe der genannten Debondmethoden zu einer Trennung von der Wachstumsschicht führt. Vorzugsweise handelt es sich bei der Löseschicht allerdings nicht um ein Polymer, da ein Polymer im erfindungsgemäßen Prozess eine unnötige, nicht gewollte Kontamination der verwendeten Analgen verursachen würde. Die Löseschicht besteht daher vorzugsweise aus einem Metall, einer Legierung oder einem Halbleitermaterial. Der Vollständigkeit halber werden die wichtigsten Materialklassen aufgezählt, die als Löseschicht verwendet werden können.
1. Halbleitermaterial, insbesondere
   1.1 Ge, Si, Alpha-Sn, B, Se, Te,
2. Metall, insbesondere
   2.1 Cu, Ag, Au, Al, Fe, Ni, Co, Pt, W, Cr, Pb, Ti, Ta, Zn, Sn,
3. Verbindungshalbleiter, insbesondere
   3.1 GaAs, GaN, InP, InxGa1-xN, InSb, InAs, GaSb, AlN, InN, GaP, BeTe, ZnO, CuInGaSe2, ZnS, ZnSe, ZnTe, CdS, CdSe, CdTe, Hg(1-x)Cd(x)Te, BeSe, HgS, AlxGa1-xAs, GaS, GaSe, GaTe, InS, InSe, InTe, CuInSe2, CuInS2, CuInGaS2, SiC, SiGe,
4. Polymere
   4.1. Kohlenstoff basierte Polymere
   4.2. Silizium basierte Polymere

Die Löseschicht besteht am allerbevorzugtesten aus einer epitaktisch erzeugten GaN Schicht. Die GaN Schicht wird dabei epitaktisch auf dem Trägersubstrat, insbesondere einem Saphirsubstrat, erzeugt. Durch die Verwendung einer sehr dünnen GaN Schicht kann auf eine kontaminierende Polymerschicht verzichtet werden.

In einer weiteren Ausführungsform ist die Löseschicht als ein Lösebereich ausgebildet, so dass auf eine Löseschicht verzichtet werden, wenn in der Wachstumsschicht und/oder dem Trägersubstrat Ionen, vorzugsweise Wasserstoffionen, implantiert werden, die bei einer thermischen Beanspruchung zu einer Schädigung der Wachstumsschicht und/oder des Trägersubstrats führen. Dieser Prozess ist in der Halbleiterindustrie als SmartCut^{™} Prozess bekannt. Somit übernimmt der Lösebereich mit den eingebrachten Ionen die Funktion der Löseschicht.

Handelt es sich bei dem Debondverfahren um ein Verfahren, bei dem elektromagnetische Strahlung, insbesondere ein Laser, verwendet wird, kann bereits durch die Dicke der Schutzschicht eine Transmission der elektromagnetischen Strahlung zur Übertragungsschicht verhindert oder zumindest reduziert werden. In diesem Fall ist die Schutzschicht dicker als 1nm, vorzugsweise dicker als 100nm, noch bevorzugter dicker als 1µm, am bevorzugtesten dicker als 100µm, am allerbevorzugtesten dicker als 1mm.

Handelt es sich bei dem Debondverfahren um ein Verfahren, bei dem Wärme verwendet wird, kann die Schutzschicht aus einem Werkstoff verwendet werden, der eine möglichst geringe Wärmeleitung besitzt, um den Wärmetransport zumindest hinauszuzögern, bis der Debondprozess beendet ist. Die Wärmeleitfähigkeit liegt zwischen 0.1 W/(m*K) und 5000 W/(m*K), vorzugsweise zwischen 1 W/(m*K) und 2500 W/(m*K), noch bevorzugter zwischen 10 W/(m*K) und 1000 W/(m*K), am bevorzugtesten zwischen 100 W/(m*K) und 450 W/(m*K)

Die dritte Schicht ist die Übertragungsschicht beziehungsweise die zu übertragende Graphenschicht, die durch einen beliebigen Prozess erzeugt, abgelegt oder abgeschieden wird.

In einer **zweiten** Ausführungsform wird auf der Graphenschicht noch mindestens eine weitere Schicht, insbesondere eine Kontaktschicht abgeschieden. Die Kontaktschicht ist vorzugsweise aus demselben Material beziehungsweise einem sehr ähnlichen Material zu einer Kontaktschicht des Produktsubstrats, sofern das Produktsubstrat auch über eine Kontaktschicht verfügt. Vorzugsweise handelt es sich bei der Kontaktschicht also ebenfalls um ein Oxid, besonders bevorzugt um ein Siliziumoxid. Insbesondere die Aufbringung eines Oxids als letzte Schicht auf der Graphenschicht hat den Vorteil, dass das Trägersubstrat nun mit Hilfe eines Fusionsbonds zum Produktsubstrat gebondet werden kann. Das Produktsubstrat weist in diesem Fall vorzugsweise ebenfalls eine Oxidschicht auf. Dadurch wird es besonders einfach, die Verbindung zwischen beiden Substraten herzustellen.

Die Kontaktschicht ist vorzugsweise hydrophil. Ein Maß für die Hydrophobizität bzw. Hydrophilität ist der Kontaktwinkel, der sich zwischen einem Testflüssigkeitstropfen, insbesondere Wasser, und der zu vermessenden Oberfläche ausbildet. Hydrophile Oberflächen verflachen den Flüssigkeitstropfen, da die Adhäsionskräftezwischen der Flüssigkeit und der Oberfläche über die Kohäsionskräfte der Flüssigkeit dominieren und bilden daher niedrige Kontaktwinkel. Hydrophobe Oberflächen führen zu einer kugelförmigeren Gestalt des Flüssigkeitstropfens, da die Kohäsionskräfte der Flüssigkeit über die Adhäsionskräfte zwischen der Flüssigkeit und der Oberfläche dominieren. Der Kontaktwinkel ist kleiner als 90°, vorzugsweise kleiner als 45°, noch bevorzugter kleiner als 30°, am bevorzugtesten kleiner als 10°, am allerbevorzugtesten kleiner als 5°. Eine hydrophile Kontaktschicht dient insbesondere einer besseren und einfacheren Übertragung.

Das Trägergrundsubstrat besteht vorzugsweise aus einem Material, das eine möglichst optimale Eigenschaft für die verwendete Debondmethode besitzt. Soll der Debondvorgang durch Wärme durchgeführt werden, bieten sich Materialien mit einer hohen Wärmeleitfähigkeit an um die Wärme schnellsten zur Löseschicht zu transportieren. Die Wärmeleitfähigkeit liegt zwischen 0.1 W/(m*K) und 5000 W/(m*K), vorzugsweise zwischen 1 W/(m*K) und 2500 W/(m*K), noch bevorzugter zwischen 10 W/(m*K) und 1000 W/(m*K), am bevorzugtesten zwischen 100 W/(m*K) und 450 W/(m*K).

Im Folgenden wird ein Prozess zur Übertragung der Graphenschicht aufgezeigt.

### Prozesse

### Trägersubstratherstellungsprozess

In einem ersten Prozessschritt eines Herstellprozesses für ein Trägersubstrat wird das Trägergrundsubstrat mit einer Lösungsschicht (engl.: release layer) beschichtet.

In einem **zweiten** Prozessschritt eines Herstellprozesses für ein Trägersubstrat wird auf der Lösungsschicht eine Wachstumsschicht aufgebracht, insbesondere abgeschieden. Die Wachstumsschicht ist vorzugsweise einkristallin. Die Herstellung einer einkristallinen Wachstumsschicht auf einer, insbesondere polymeren, Lösungsschicht ist nahezu unmöglich. In einer besonderen Ausführungsform wird daher die Wachstumsschicht nicht durch einen Abscheideprozess auf der Lösungsschicht erzeugt, sondern durch einen anderen Schichtübertragungsprozess auf die Lösungsschicht übertragen. Denkbar wäre hierbei der SmartCut^{™} Prozess. Jeder andere Prozess zur Schichtübertragung wäre ebenfalls geeignet.

In einem **dritten** Prozessschritt eines Herstellprozesses für ein Trägersubstrat wird auf der Wachstumsschicht eine Übertragungsschicht angeordnet beziehungsweise erzeugt. Bei der Übertragungsschicht handelt es sich vorzugsweise um eine Graphenschicht, welche erzeugt beziehungsweise gezüchtet wird. Die Züchtung der Graphenschicht kann dabei durch jede bekannte Methode aus dem Stand der Technik erfolgen.

Denkbar wäre beispielsweise, dass in der erzeugten Wachstumsschicht Kohlenstoffatome bei höheren Temperaturen gelöst wurden und das System in einem weiteren Zwischenschritt soweit abgekühlt wird, dass die Löslichkeit des Kohlenstoffs im Material unterschritten wird. Dadurch wird Kohlenstoff, insbesondere auch an der Oberfläche, ausgeschieden und kann eine Graphenschicht ausbilden.

In einer anderen Ausführungsform befindet sich der Kohlenstoff nicht in der Wachstumsschicht, sondern wird der Wachstumsschicht von außen durch entsprechende Abscheideprozesse zugeführt. Denkbar ist beispielsweise die Verwendung von Molekularstrahlepitaxie, PVD oder CVD Prozessen etc.

In einer Erweiterung des dritten Prozessschrittes wird auf der Übertragungsschicht beziehungsweise der Graphenschicht eine weitere Schicht abgeschieden, die insbesondere zur Optimierung der Kontaktierung in späteren Prozessschritten dient. Daher wird diese Schicht als Kontaktierungsschicht bezeichnet. Die Kontaktierungsschicht ist insbesondere eine Oxidschicht und vorzugsweise aus demselben Material wie eine Kontaktschicht des Produktsubstrates.

### Schichtübertragungsprozess

Im Folgenden wird der Schichtübertragungsprozess ausführlich beschrieben.

In einem **ersten** Prozessschritt wird das Trägersubstrat relativ zum Produktsubstrat ausgerichtet. Die Ausrichtung erfolgt dabei mechanisch und/oder optisch. Vorzugsweise werden eigene Ausrichtungsanlagen verwendet, die Träger- und Produktsubstrat anhand von Ausrichtungsmarken zueinander ausrichten.

In einem **zweiten** Prozessschritt wird das Trägersubstrat relativ zum Produktsubstrat kontaktiert. Die Kontaktierung kann dabei entweder sofort vollflächig oder durch einen Punktkontakt erfolgen. Vorzugsweise wird eine Fusionsbondanlage verwendet.

In einem **dritten** Prozessschritt wird das Trägergrundsubstrat mit Hilfe eines Debondverfahrens, insbesondere mit Hilfe eines Lasers, entlang der Löseschicht von der Wachstumsschicht abgetrennt. Dabei wirkt die Wachstumsschicht als Barriere gegenüber der Graphenschicht. Die Wachstumsschicht ist vorzugsweise so konzipiert, dass das verwendete Debondverfahren, insbesondere der Laser, die Übertragungsschicht beziehungsweise die Graphenschicht nicht beeinträchtigt, insbesondere nicht zerstört. Dadurch wird der Schichtaufbau zu einem neuen Merkmal im Gegensatz zum Stand der Technik. Die einzelnen möglichen Debondverfahren werden im Weiteren näher beschrieben.

### Debondverfahren

In einem **ersten,** bevorzugten Debondverfahren wird eine elektromagnetische Strahlung, insbesondere ein Laser verwendet. Das Trägergrundsubstrat ist zumindest teilweise transparent für die elektromagnetische Strahlung, während die Löseschicht vorzugsweise maximal absorbierend ist. Die Wachstumsschicht ist ebenfalls bezüglich der elektromagnetischen Strahlung absorbierend, sodass diese insbesondere die Photonen, die nicht von der Löseschicht absorbiert wurden, daran gehindert werden zur nachgeordneten Übertragungsschicht beziehungsweise Graphenschicht vorzudringen.

Die Löseschicht besitzt vorzugsweise eine hohe Löslichkeit für Wasser. Entsprechend wäre die Verwendung einer Mikrowellenquelle zur lokalen Einbringung von Wärme durch eine kapazitive Erwärmung des Wassers eine weitere, denkbare Möglichkeit zum Debonden.

In einem **zweiten,** weniger bevorzugten Debondverfahren wird die Löseschicht mit einem elektrischen und/oder magnetischen Feld beaufschlagt. Die Löseschicht ist dann so konzipiert, dass beim Überschreiten einer bestimmten elektrischen und/oder magnetischen Feldstärke ein physikalischer Effekt zu einer Auflösung der Löseschicht oder zumindest zu einer Verminderung der Adhäsion der Löseschicht zur Wachstumsschicht und/oder zum ersten Substrat erfolgt.

In einem **dritten,** am wenigsten bevorzugten Debondverfahren wird Wärme verwendet. Die Wärmequelle befindet sich dabei vorzugsweise auf der Seite des Trägergrundsubstrats. Vorzugsweise befindet sich auf der Seite des Produktgrundsubstrats eine Wärmesenke, insbesondere eine aktive Kühlung. Die Wärme wird vorzugsweise bis zur Löseschicht transportiert, um dort eine Trennung zwischen dem Trägersubstrat beziehungsweise der Löseschicht und der Wachstumsschicht zu bewirken. Vorzugsweise ist die thermische Belastung der Übertragungsschicht beziehungsweise der Graphenschicht minimal. Entsprechend sollte in diesem Fall die Wachstumsschicht so ausgelegt sein, dass sie ein schlechter Wärmeleiter und idealerweise auch ein schlechter Wärmespeicher ist. Diese Ausführungsform ist wenig bevorzugt, da durch die Erzeugung einer erhöhten Temperatur eine Wärmedehnung der unterschiedlichen Schichten des Schichtsystems erfolgt. Im Allgemeinen weist eine jede Schicht einen unterschiedlichen thermischen Ausdehnungskoeffizienten aus. Sollte die Löseschicht polymerbasiert sein, kann zwar eine thermische Spannung durch Verfließen abgebaut werden, allerdings sind andere Schichten des Schichtsystems viel anfälliger für thermische Spannungen.

In einem **vierten** Prozessschritt kann mit der Wachstumsschicht unterschiedlich verfahren werden.

In einer **ersten Variante des vierten** Prozessschritts wird die Wachstumsschicht einfach entfernt, sodass die Übertragungsschicht beziehungsweise die Graphenschicht freigelegt wird. Die Entfernung kann durch chemische und/oder physikalische Prozess erfolgen. Die Entfernung der Wachstumsschicht ist insbesondere dann unabdingbar, wenn die Übertragungsschicht beziehungsweise die Graphenschicht erst nach der Schichtübertragung strukturiert werden muss.

In einer **zweiten Variante des vierten** Prozessschritts wird die Wachstumsschicht durch mehrere Prozessschritte strukturiert um als Ätzmaske für die darunterliegende Übertragungsschicht beziehungsweise die Graphenschicht zu dienen. Nach dem Ätzen der Übertragungsschicht beziehungsweise der Graphenschicht kann die nun strukturierte Ätzschicht vollständig entfernt werden, da sie als Ätzmaske nun nicht mehr benötigt wird.

In einer **dritten Variante des vierten** Prozessschritts wird die Wachstumsschicht selbst als Funktionalschicht oberhalb der Übertragungsschicht beziehungsweise der Graphenschicht belassen und, sofern notwendig, strukturiert. Da es sich bei der Wachstumsschicht aber in den allermeisten Fällen um ein Elektrikum, das heißt um eine leitfähige, insbesondere metallische Schicht handelt, welche eine allfällig strukturierte Übertragungsschicht beziehungsweise Graphenschicht über insbesondere die gesamte Fläche kurzschließen würde, wird sie in den meisten Fällen entfernt werden.

In einer anderen Ausführungsform handelt es sich bei der Debondmethode um eine einfache mechanische Trennung. Die beiden Substrate werden dabei so fixiert, dass bei der Beaufschlagung mindestens eines der beiden Substrate eine Spannung, vorzugsweise eine Zugspannung zwischen der Löseschicht und der Wachstumsschicht entsteht, sodass die Löseschicht von der Wachstumsschicht getrennt wird. Vorteilhafter wäre natürlich, dass die Trennung zwischen der Übertragungsschicht und der Wachstumsschicht erfolgen würde. In diesem Fall könnte auf eine Löseschicht gänzlich verzichtet werden. Des Weiteren müsste die Wachstumsschicht nicht in weiteren Prozessschritten von der Übertragungsschicht entfernt werden. Allerdings ist die Adhäsion zwischen der Übertragungsschicht und der Wachstumsschicht meistens sehr stark ist, sodass dieser bevorzugte Fall fast nie auftreten wird. Die aufzuwendende Kraft, um die beiden Substrate voneinander zu trennen wird vorzugsweise kleinflächig, insbesondere punktförmig, insbesondere an mindestens einem Punkt der Peripherie der Substrate, aufgebracht. Die Kraft ist dabei größer als 0.01N, vorzugsweise größer als 0.1N, noch bevorzugter größer als 1N, am bevorzugtesten größer als 10N, am allerbevorzugtesten größer als 100N. Die mechanische Trennung kann besonders leicht erfolgen, wenn in der Löseschicht eine Sollbruchstelle erzeugt wird. Die Sollbruchstelle kann mit einer Klinge, insbesondere einer Rasierklinge, einem Draht oder einer Düse, die ein Fluid auf die Löseschicht presst, erzeugt werden.

Allerdings ist die Verwendung von elektromagnetischer Strahlung zum Debonden besonders bevorzugt. Insbesondere ist die Verwendung eines Lasers als Debondmittel die bevorzugte Methode zum Debonden. In diesem Fall sollte das Trägersubstrat eine möglichst hohe Transparenz, genauer Transmissivität, für die verwendete elektromagnetische Strahlung besitzen. Vorzugsweise ist das Trägersubstrat ein Glassubstrat, am allerbevorzugtesten ein Saphirsubstrat sein. Die Transparenz soll durch den Transmissionsgrad beschrieben werden, der das Verhältnis aus transmittierter und eingestrahlter Strahlung angibt. Der Transmissionsgrad ist allerdings von der Dicken des durchstrahlten Körpers abhängig und damit keine materialspezifische Eigenschaft. Die Werte des Transmissionsgrades werden daher auf eine Einheitslänge von 1 cm bezogen angegeben. Das Material besitzt in Bezug auf die gewählte Dicke von einem 1 cm und für die jeweils gewählte Wellenlänge insbesondere einen Transmissionsgrad größer 10%, vorzugsweise größer 20%, noch bevorzugter größer 50%, am bevorzugtesten größer als 75%, am allerbevorzugtesten größer 99%.

Weitere Vorteile, Merkmale und Einzelheiten der Erfindung ergeben sich aus der nachfolgenden Beschreibung bevorzugter Ausführungsbeispiele sowie anhand der Zeichnungen. Die zeigen schematisch in:
- Figur 1: eine erste Ausführungsform eines nicht unter den Schutzumfang der Asprüche fallenden Trägersubstrats,
- Figur 2: eine zweite Ausführungsform eines Trägersubstrats,
- Figur 3: eine erste Ausführungsform eines Produktsubstrats,
- Figur 4: eine zweite Ausführungsform eines Produktsubstrats,
- Figur 5: eine dritte Ausführungsform eines Produktsubstrats,
- Figur 6a: einen ersten Prozessschritt eines ersten erfindungsgemäßen Verfahrens,
- Figur 6b: einen zweiten Prozessschritt eines ersten erfindungsgemäßen Verfahrens,
- Figur 6c: einen dritten Prozessschritt eines ersten erfindungsgemäßen Verfahrens und
- Figur 6d: einen vierten Prozessschritt eines ersten erfindungsgemäßen Verfahrens.

In den Figuren sind gleiche Bauteile oder Bauteile mit der gleichen Funktion mit den gleichen Bezugszeichen gekennzeichnet.

In den Figuren wird auf die Darstellung unnötiger Bauteile, insbesondere der Substrathalter gänzlich verzichtet, da sie nicht notwendig sind, um den Prozess zu beschreiben. Die Figuren sowie die Einzelteile der Darstellungen sind nicht maßstabsgetreu. Durch die nicht maßstabsgetreue Darstellung erhöht sich die Verständlichkeit der Figuren. Insbesondere wird die Übertragungsschicht 6, welche im Folgenden exemplarisch in Form einer Graphenschicht 6 beschrieben wird, sehr dick eingezeichnet, obwohl es sich dabei nur um eine monoatomare Schicht handelt. Zudem wird in den Figuren die Schutzschicht 5 beziehungsweise die Wachstumsschicht 5 als eine Schicht abgebildet. Dies ist die bevorzugte Ausführungsform, in welcher die Schutzschicht 5 neben dem Schutz auch als Wachstumsschicht 5 ausgebildet ist. In jedem Fall ist eine Schutzschicht 5 vorgesehen. Denkbar ist jedoch auch das auf der Schutzschicht 5 eine zusätzliche Wachstumsschicht angeordnet ist, um die Übertragungsschicht 6 zu erzeugen. Bevorzugt ist jedoch eine Schicht mit der Schutzfunktion, welche auch zum Erzeugen beziehungsweise züchten einer Übertragungsschicht 6 geeignet ist.

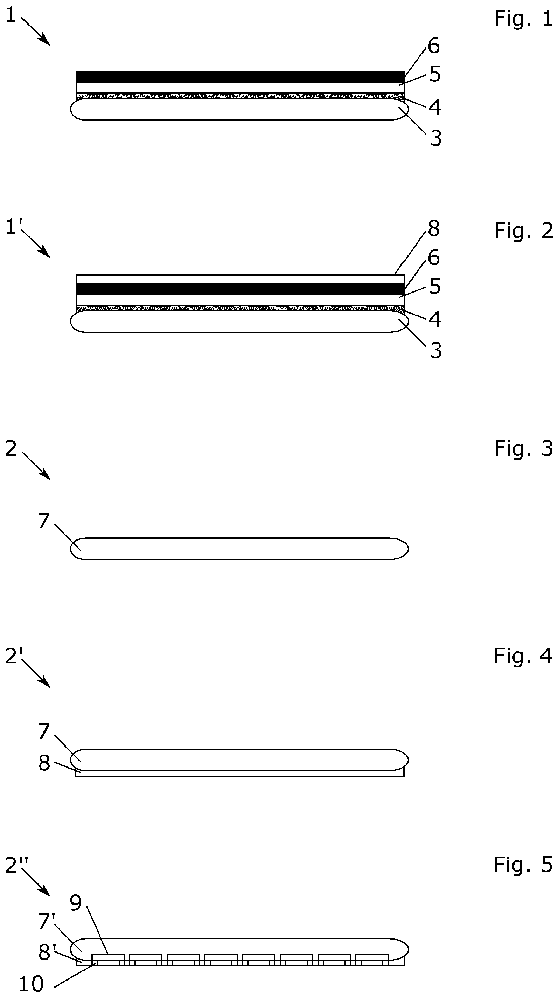

Die **Figur 1** zeigt ein Trägersubstrat 1 mit einem hergestellten Schichtsystem in einer ersten Ausführungsform. Das Schichtsystem besteht aus einer Löseschicht 4, die auf dem Trägergrundsubstrat 3 aufgebracht wurde. Auf der Löseschicht 4 befindet sich eine Wachstumsschicht 5 beziehungsweise eine Schutzschicht 5. Die Wachstumsschicht 5 wurde vorzugsweise selbst durch einen Schichtübertragungsprozess auf die Löseschicht 4 übertragen oder durch einen physikalischen oder chemischen Abscheideprozess direkt auf der Löseschicht 4 abgeschieden. Auf der Wachstumsschicht 5 wurde eine Übertragungsschicht 6 beziehungsweise die Graphenschicht 6 erzeugt. Die Dicken des Trägergrundsubstrats 3, der Löseschicht 4, der Wachstumsschicht 5 und insbesondere der Graphenschicht 6 sind nicht maßstabsgetreu dargestellt. Insbesondere müsste die Graphenschicht 6 als monoatomare Schicht sehr viel dünner, insbesondere nur als einzelner Strich dargestellt werden. Um die Darstellung zu verbessern, wird auf eine maßstabsgetreue Darstellung allerdings verzichtet.

Die **Figur 2** zeigt ein Trägersubstrat 1' mit einem hergestellten Schichtsystem in einer zweiten Ausführungsform. Das Trägersubstrat 1' besitzt auf der Übertragungsschicht 6 beziehungsweise der Graphenschicht 6 noch eine abgeschiedene oder übertragene Kontaktschicht 8.

Die **Figur 3** zeigt ein Produktsubstrat 2 in einer ersten Ausführungsform. Das Produktsubstrat 2 besteht insbesondere nur aus dem Produktgrundsubstrat 7.

Die **Figur 4** zeigt ein Produktsubstrat 2' in einer zweiten Ausführungsform. Das Produktsubstrat 2' besteht aus einem Produktgrundsubstrat 7 und einer darauf abgeschiedenen oder übertragenen Kontaktschicht 8. Bei der Kontaktschicht 8 handelt es sich vorzugsweise um eine dielektrische Schicht, am allerbevorzugtesten um eine Siliziumoxidschicht.

Die **Figur 5** zeigt ein Produktsubstrat 2'' in einer dritten Ausführungsform. Das Produktsubstrat 2'' besteht aus einem Produktgrundsubstrat 7'. Im Produktgrundsubstrat 7' wurden bereits, insbesondere funktionale, Bauteile 9 hergestellt. Vorzugsweise wurde eine Kontaktschicht 8' über dem Produktgrundsubstrat 7' abgeschieden. Die Kontaktschicht 8' weist vorzugsweise elektrisch leitende Durchkontaktierungen 10 auf, welche die, insbesondere funktionalen, Bauteil 9 mit der zu übertragenden Übertragungsschicht beziehungsweise Graphenschicht (nicht eingezeichnet) verbinden sollen. Diese Ausführungsform wäre auch ohne der Kontaktschicht 8' denkbar. In diesem Fall würden die Durchkontaktierungen 10 ebenfalls entfallen und eine übertragene Übertragungsschicht beziehungsweise Graphenschicht (nicht eingezeichnet) würde Kontaktstellen der, insbesondere funktionalen, Bauteile 9 (nicht eingezeichnet) direkt kontaktieren. Bei der Kontaktschicht 8' handelt es sich wiederum vorzugsweise um eine dielektrische Schicht, am allerbevorzugtesten um eine Siliziumoxidschicht.

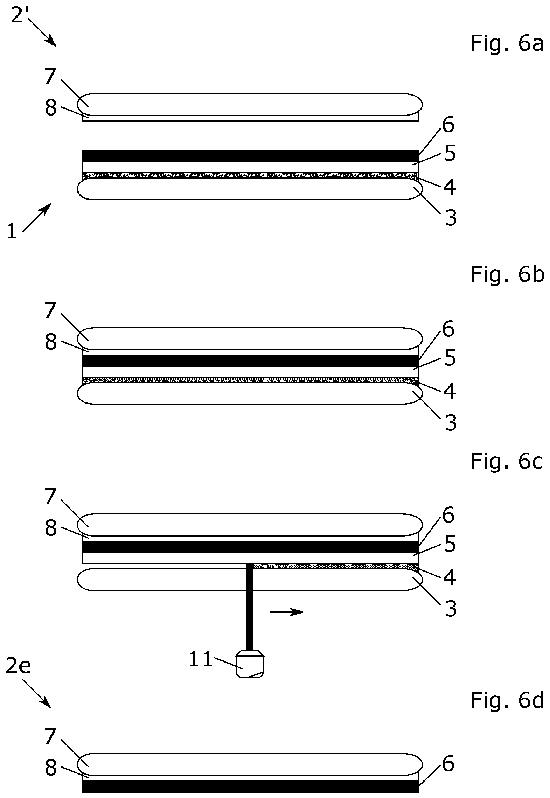

Die folgenden Figuren 6a bis 6d zeigen ein erstes Verfahren beziehungsweise einen Prozess zum Übertragen einer Übertragungsschicht exemplarisch anhand eines Trägersubstrats 2' und eines Produktsubstrats 2'. Der Prozess kann allerdings durch jede beliebige Trägersubstrat-Produktsubstrat Kombination durchgeführt werden, insbesondere auch durch Trägersubstrate und/oder Produktsubstrate, die nicht explizit dargestellten werden, sofern das Schichtsystem, bestehend aus der Löseschicht 4, der Wachstumsschicht 5 sowie der zu übertragenden Übertragungsschicht 6 beziehungsweise der Graphenschicht 6, insbesondere in dieser Reihenfolge, vorhanden sind.

Des Weiteren wird in den folgenden Figuren das Produktsubstrat 2' an der Oberseite und das Trägersubstrat 1' an der Unterseite dargestellt. Denkbar ist auch, dass sich das Trägersubstrat 1' an der Oberseite und das Produktsubstrat 1' an der Unterseite befindet. Auf die Darstellung von Substrathaltern, Bond- und Ausrichtungsvorrichtungen wird der Übersichtlichkeit halber verzichtet.

Die **Figur 6a** zeigt einen ersten Prozessschritt eines ersten Verfahrens beziehungsweise eines ersten Prozesses zum Übertragen einer Übertragungsschicht, bei dem ein Produktsubstrat 2', bestehend aus einem Produktgrundsubstrat 7 und einer Kontaktschicht 8, relativ zu einem Trägersubstrat 1 ausgereichtet wird. Bei der Kontaktschicht 8 handelt es sich vorzugsweise um ein Oxid, am allerbevorzugtesten um ein Siliziumoxid. Das Trägersubstrat 1 besteht aus einem Trägergrundsubstrat 3, einer Löseschicht 4, einer Wachstumsschicht 5, sowie der zu übertragenden Übertragungsschicht 6 beziehungsweise Graphenschicht 6. Wie die Graphenschicht 6 auf der Wachstumsschicht 5 erzeugt wurde oder übertragen wurde ist für das Verständnis des Prozesses nicht von Relevanz und wird daher nicht näher beschrieben. Die Ausrichtung kann mechanisch und/oder optisch erfolgen. Bei einer optischen Ausrichtung befinden sich insbesondere Ausrichtungsmarken (nicht eingezeichnet) auf dem Produktsubstrat 2' und dem Trägersubstrat 1.

Die **Figur 6b** zeigt einen zweiten Prozessschritt des ersten Prozesses, bei dem eine Kontaktierung zwischen dem Trägersubstrat 1 und dem Produktsubstrat 2' stattfindet. In der Figur wird nicht dargestellt wie die Kontaktierung genau erfolgt, da das für den Prozess nicht von Relevanz ist. Vorzugsweise erfolgt die Kontaktierung allerdings durch eine Vorrichtung, bei der mindestens eines der beiden Substrate 1, 2' gekrümmt wird. Der Kontaktierungsprozess wird daher vorzugsweise mit Hilfe einer Fusionsbondanlage durchgeführt. In einer ganz besonders bevorzugten Ausführungsform des Prozesses wird das, insbesondere obere, Produktsubstrat 2' gekrümmt, während das, insbesondere untere, Trägersubstrat 1 vollflächig fixiert wird.

Die **Figur 6c** zeigt einen dritten Prozessschritt des ersten Prozesses. Die Löseschicht 4 wird durch ein Debondmittel 11 beaufschlagt. Vorzugsweise handelt es sich bei dem Debondmittel 11 um einen Laser. Das Debondmittel wirkt vorzugsweise über das Trägergrundsubstrat 3 auf die Löseschicht 4. Dabei wirkt die Wachstumsschicht 5 als Schutzschild für die dahinterliegende Graphenschicht 6. Da die Graphenschicht 6 eine monoatomare Schicht ist, könnte die Graphenschicht 6 durch Debondmittel 11 mit hohen Intensitäten zerstört werden. Die Wachstumsschicht 5, die vorzugsweise auch zur Erzeugung der Graphenschicht 6 verwendet wird, wird somit als Schutzschild verwendet. Die Wachstumsschicht 5 muss daher so ausgelegt sein, dass das jeweils verwendete Debondmittel 11 bei dem Debondvorgang bestmöglich blockiert wird beziehungsweise vom Debondmittel 11 ausgehende Einflüsse auf die Übertragungsschicht 6 zumindest sehr stark reduziert. Handelt es sich bei dem Debondmittel 11 um einen Laser, so sollte die Wachstumsschicht 5 eine möglichst geringe Transmissivität für die Photonen des Lasers 11 aufweisen. Handelt es sich bei dem Debondmittel 11 beispielsweise um Wärme, die durch eine Wärmequelle eingebracht wird, sollte die Wachstumsschicht 5 eine möglichst geringe Wärmeleitfähigkeit besitzen, um den Wärmetransport zur Graphenschicht 6 zu erschweren.

Dem Fachmann auf dem Gebiet ist klar, dass sich zwischen der Löseschicht 4 und der Wachstumsschicht 5 beliebig viele andere Schichten befinden können, welche die besondere Aufgabe des Schutzes der Übertragungsschicht 6 erfüllen können. So wäre es denkbar, zwischen der Löseschicht 4 und der Wachstumsschicht 5 eine weitere Schicht einzufügen, welche die Laserstrahlung oder Wärme eines Debondmittels 11 extrem gut absorbiert. Der Einfachheit halber wird diese Eigenschaft aber in einer einzelnen Wachstumsschicht 5 zusammengefügt, um weder die Beschreibung noch die Darstellung zu verkomplizieren. Insbesondere ist es von Vorteil, wenn die Wachstumsschicht 5, welche vorzugsweise zur Züchtung der Graphenschicht 6 verwendet wird, gleichzeitig auch als deren Schutzschicht für die angewandten Debondmittel 11 dient. Dadurch kann ein sehr kosteneffizienter Prozess durchgeführt werden, weil es nicht notwendig ist, weitere teure Schichten abzuscheiden. Ein weiterer Vorteil besteht darin, dass es sich bei der Wachstumsschicht 5 besonders bevorzugt um eine Metallschicht, am bevorzugtesten um eine Nickelschicht handelt. Bekanntermaßen sind Metalle sehr gute Infrarotabsorber. Das bevorzugteste Debondmittel 11 ist ein Laser, vorzugsweise eine Infrarotlaser. Die metallische Wachstumsschicht 11 kann in diesem speziellen Fall daher aufgrund ihrer Festkörpereigenschaften gleichzeitig als Wachstumsschicht 5 und als Schutzschicht dienen. Wäre das Debondmittel 11 eine Wärmequelle, wäre eine metallische Wachstumsschicht 5 wegen der relativ Hohen Wärmeleitfähigkeit natürlich eher suboptimal. In diesem Fall sind vorzugsweise weitere Schichten zwischen der Wachstumsschicht 5 und der Löseschicht 4 einfügen, insbesondere solche mit geringer thermischer Leitfähigkeit.

Die **Figur 6d** zeigt eine erste Variante eines vierten Prozessschritt des ersten Prozesses, bei dem die ebenfalls übertragen Wachstumsschicht 5 (nicht mehr eingezeichnet) bereits entfernt wurde. Somit erhält man eine Übertragungsschicht 6 beziehungsweise eine Graphenschicht 6, auf einem Produktsubstrat 2e, welches das Endprodukt des Prozesses darstellt. Das Produktsubstrat 2e, insbesondere die übertragene Graphenschicht 6, kann dann in weiteren Prozessschritten weiterverarbeitet werden. Die beiden anderen Varianten für die Verwendung der Wachstumsschicht 5, die bereits erwähnt wurden, werden hier nicht mehr bildlich dargestellt, da man aus ihnen keine weiteren Rückschlüsse auf das eigentliche Verfahren ziehen kann.

### Bezugszeichenliste

- 1: Trägersubstrat
- 2, 2', 2",2e: Produktsubstrat
- 3: Trägergrundsubstrat
- 4: Löseschicht
- 5: Wachstumsschicht, Schutzschicht
- 6: Übertragungsschicht, Graphenschicht
- 7, 7': Produktgrundsubstrat
- 8, 8': Kontaktschicht
- 9: Funktionale Einheiten
- 10: Durchkontaktierung
- 11: Debondmittel

## Patentansprüche

1. Verfahren zur Herstellung eines Trägersubstrates (1) zum Übertragen einer Übertragungsschicht (6) von dem Trägersubstrat (1) auf ein Produktsubstrat (2, 2', 2'', 2e) mit den folgenden Schritten:
i) Bereitstellen eines Trägergrundsubstrates (3),
ii) Aufbringen einer Schutzschicht (5) auf dem Trägergrundsubstrat (3),
iii) Züchten einer Übertragungsschicht (6), insbesondere einer Graphenschicht, auf der Schutzschicht (5), wobei die Schutzschicht (5) aus mehreren einzelnen Schichten besteht,
**dadurch gekennzeichnet, dass** vor dem Aufbringen der Schutzschicht (5) in Schritt ii) das Trägergrundsubstrat (3) mit einer Löseschicht (4) beschichtet wird, so dass die Schutzschicht (5) auf der Löseschicht (4) aufgebracht wird.

2. Verfahren nach Anspruch 1, wobei vor dem Züchten der Übertragungsschicht (6) in Schritt iii) die Schutzschicht (5) rekristallisiert wird.

3. Verfahren nach wenigstens einem der vorhergehenden Ansprüche, wobei auf der Übertragungsschicht (6) auf der der Schutzschicht (5) abgewandten Seite eine Kontaktschicht (8, 8') abgeschieden wird.

## Claims

1. A method for the preparation of a carrier substrate (1) for transferring a transfer layer (6) from the carrier substrate (1) onto a product substrate (2, 2', 2", 2e) with the following steps.
i) provision of a carrier base substrate (3),
(ii) application of a protective layer (5) on the carrier base substrate (3),
(iii) breeding of a transfer layer (6), in particular a graphene layer, on the protective layer (5), wherein the protective layer (5) consists of a plurality of individual layers,
**characterised in that** the carrier base substrate (3) is coated with a release layer (4) before the application of the protective layer (5) in step ii), so that the protective layer (5) is applied to the release layer (4).

2. The method according to claim 1, wherein the protective layer (5) is recrystallised prior to the breeding of the transfer layer (6) in step iii) .

3. The method according to at least one of the preceding claims, wherein a contact layer (8, 8') is deposited on the transfer layer (6) on the side facing away from the transfer layer (5).

## Revendications

1. Procédé de fabrication d'un substrat porteur (1) pour le transfert d'une couche de transfert (6) du substrat porteur (1) vers un substrat de produit (2, 2', 2", 2e) en procédant comme suit :
i) mise à disposition d'un substrat porteur de base (3) ;
ii) application d'une couche de protection (5) sur le substrat porteur de base (3) ;
iii) développement d'une couche de transmission (6), en particulier d'une couche de graphène, sur la couche de protection (5), la couche de protection (5) étant composée de plusieurs couches distinctes ;
**caractérisé en ce qu'**avant d'appliquer la couche de protection (5) à l'étape ii), le substrat de support (3) est enduit d'une couche de détachement (4), de sorte que la couche de protection (5) est appliquée sur la couche de détachement (4).

2. Procédé selon la revendication 1, dans lequel, avant le développement de la couche de transmission (6) à l'étape iii), la couche de protection (5) est recristallisée.

3. Procédé selon au moins l'une des revendications précédentes, dans lequel une couche de contact (8, 8') est déposée sur la couche de transmission (6) du côté opposé à la couche de protection (5).
